# FASCICULE DE BREVET EUROPEEN

(11) **EP 0 378 635 B1**
(45) Date de publication et mention de la délivrance du brevet: **13.04.1994**
(21) Numéro de dépôt: 89907200.3
(22) Date de dépôt: 16.06.1989
(51) Int. Cl.: H03L 1/04

(54) **OSCILLATEUR ULTRASTABLE FONCTIONNANT A PRESSION ATMOSPHERIQUE ET SOUS VIDE**
OSZILLATOR HOHER FREQUENZSTABILITÄT FÜR DEN BETRIEB BEI NORMALEM LUFTDRUCK UND IM VAKUUM
ULTRASTABLE OSCILLATOR OPERATING AT ATMOSPHERIC PRESSURE AND IN VACUO

(30) Priorité: 24.06.1988 FR 8808523
(43) Date de publication de la demande: 25.07.1990
(73) Titulaire: COMPAGNIE D'ELECTRONIQUE ET DE PIEZO-ELECTRICITE - C.E.P.E., F-95105 Argenteuil (FR)
(72) Inventeur: GERARD, Evelyne, F-78600 Maisons-Lafitte (FR); MOLLE, Roger, F-92160 Antony (FR); DEBAISIEUX, André, F-95220 Herblay (FR)
(74) Mandataire: Guérin, Michel
(86) Numéro de dépôt international: FR8900307
(87) Numéro de publication internationale: WO8912929

(56) Documents cités:
- EP-A- 0 142 410
- DE-A- 2 360 398
- DE-A-18 061 14
- FR-A- 700 180
- US-A- 3 007 023
- US-A- 3 252 109
- US-A- 3 617 692

## Description

La présente invention concerne un oscillateur à résonateur piézoélectrique, ultrastable en fréquence et fonctionnant aussi bien à pression atmosphérique que dans le vide.

Les oscillateurs à résonateur piézoélectrique constituent des bases de temps pour un grand nombre d'appareillages. Ces bases de temps doivent être aussi précises que possible. Les paramètres qui jouent sur la stabilité de fréquence sont nombreux : température, pression, vibrations, chocs, âge, démarrages et arrêts... Les variations de température et de pression en particulier, influent de manière très importante sur la stabilité de fréquence d'un oscillateur à résonateur piézoélectrique.

Les oscillateurs embarqués dans les satellites doivent fonctionner avec une grande stabilité de fréquence aussi bien à pression atmosphérique avant le lancement, que dans le vide lorsque le satellite est en orbite. De plus les variations de température ne se manifestent pas de la même manière lorsque l'on se place dans le vide ou dans l'atmosphère, car dans le vide il n'y a pas de convection.

Les matériaux utilisés dans les oscillateurs destinés à fonctionner aussi bien dans le vide qu'à pression atmosphérique doivent répondre à un certain nombre de critères. Ils doivent tout d'abord respecter les règles spatiale notamment en ce qui concerne le taux de condensat et le taux de perte de poids. Ils doivent également garantir une faible variation de résistance thermique de façon à minimiser les variations de températures lors du passage de la pression atmosphérique au vide et vice et versa.

Les oscillateurs à résonateur piézoélectrique ultrastables de type connu sont généralement insérés dans un vase Dewar afin de garantir une bonne isolation thermique vis-à-vis de l'extérieur.

Il est connu par le document US-A- 3 617 692 de placer le résonateur à quartz d'un oscillateur dans une enceinte thermostatée formée de deux cuves encastrées l'une dans l'autre. La cuve externe est en matériau isolant thermique et la cuve interne à deux parois métalliques séparées par un isolant thermique. Mais rien, n'est prévu pour que l'oscillateur ait une bonne stabilité de fréquence aussi bien sous vide qu'à pression atmosphérique.

La présente invention propose un oscillateur à résonateur piézoélectrique ultrastable en fréquence dont les performances de stabilité en fréquence sont obtenues grâce à un montage permettant d'éviter l'utilisation d'un vase Dewar.

La présente invention propose un oscillateur ultrastable en fréquence comprenant un résonateur piézoélectrique constitué d'une lame piézoelectrique encapsulée dans un boîtier composé d'un capot et d'une embase, le résonateur étant placé dans une enceinte thermostatée comprenant des côtes limités par un fond et au moins un couvercle l'enceinte thermostatée étant constituée d'une cuve interne encastrée dans une cuve externe, leurs côtés étant en contact direct et leurs fonds formant le fond de l'enceinte thermostatée caractérisé en ce que la surface extérieure du capot du résonateur est en contact thermique étroit avec les côtés et le fond de la cuve interne, et en ce que la cuve interne est vissée a l'intérieur de la cuve externe, la cuve interne et la cuve externe étant réalisées chacune dans un matériau conducteur de la chaleur de manière à ce que l'oscillateur ait des performances de stabilité en fréquence aussi bonnes que possibles à pression atmosphérique et sous vide.

Un joint thermique tendre pourra être inséré entre le fond de la cuve interne et le fond de la cuve externe.

Le capot du résonateur peut être brasé sur toute sa surface extérieure a l'intérieur de la cuve interne.

L'enceinte thermostatée sera insérée dans une enceinte intermédiaire, un espace étroit étant réalisé entre les deux enceintes de façon à minimiser les phénomènes de convection lorsque que l'on travaille à pression atmosphérique.

La surface intérieure de l'enceinte intermédiaire sera brillante afin de minimiser les pertes thermiques par rayonnement de l'enceinte thermostatée.

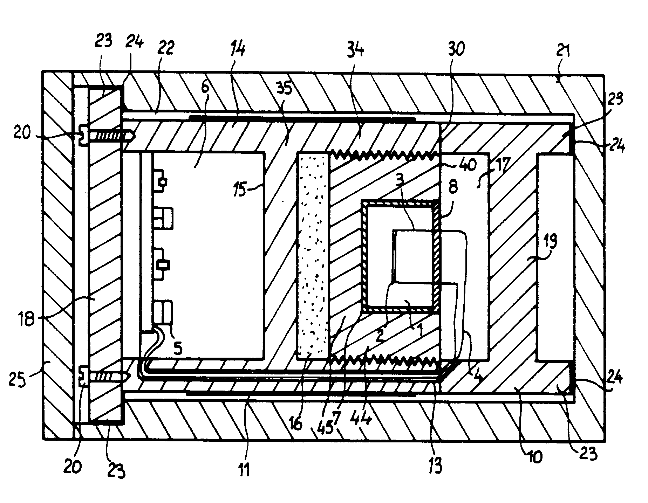

L'invention sera mieux comprise et d'autres avantages apparaîtront au moyen de la description qui va suivre, donnée à titre non limitatif et agrémentée de la figure unique qui représente une vue en coupe d'un oscillateur à résonateur piézoélectrique ultrastable selon l'invention.

Sur cette figure, le résonateur piézoélectrique 1 comprend une lame de matériau piézoélectrique 2 maintenue par deux poteaux 3 conducteurs auxquels sont fixés des fils électriques 4 assurant la liaison électrique avec un circuit oscillateur 5.

Le lame piézoélectrique 2 est encapsulée dans un boitier constitué d'un capot 7 et d'une embase 8. Le résonateur 1 est placé à l'intérieur d'une enceinte thermostatée 10 comprenant un fond 15 et des côtés 14.

L'enceinte thermostatée 10 peut comme sur notre figure être constituée par deux cavités 6, 17 placées dos à dos et possédant le même fond 15.

La première cavité 6 contient le circuit électronique 5 constituant l'oscillateur piézoélectrique. Il est en effet préférable, pour la bonne marche de l'oscillateur que ce circuit électronique 5 soit placé dans une enceinte thermostatée. La deuxième cavité 17 contient le résonateur piézoélectrique 1.

Dans la réalisation représentée sur notre figure, la deuxième cavité de l'enceinte thermostatée 10 est constituée d'une cuve externe 30 dans laquelle est encastrée une cuve interne 40. Les deux cuves 30, 40 sont solidaires l'une de l'autre. La cuve externe 30 possède des côtés 34 et un fond 35. La cuve interne 40 possède des côtés 44 et un fond 45. Les deux cuves 30, 40 sont en contact direct au moins par leurs côtés 34, 44.

Dans cette réalisation, le capot 7 du résonateur piézoélectrique 1 est en contact sur toute la surface extérieure avec les côtés 44 et le fond 45 de la cuve interne 40. Ce contact peut être réalisé par brasage.

Le capot 7 étant généralement de forme cylindrique la cuve interne 40 sera aussi de forme cylindrique. Ses côtés 44 peuvent porter sur leur surface extérieure un pas de vis. La cuve interne 40 peut être vissée à l'intérieur de la cuve externe 30. Les côtés 34 de la cuve externe 30 porteront aussi sur leur surface intérieure un pas de vis de dimensions appropriées. Les deux cuves seront ainsi solidaires.

Un joint 16 thermique en matériau métallique tendre est inséré entre le fond 35 de la cuve externe 30 et le fond 45 de la cuve interne 40. Ce joint 16 est écrasé lorsque la cuve interne 40 est vissée à l'intérieur de la cuve externe 30. Il permet d'améliorer la conduction thermique entre le résonateur 1 et l'enceinte thermostatée 10. Ce joint 16 thermique est réalisé dans un matériau métallique bon conducteur de la chaleur tel que l'indium, l'or, l'argent, le cuivre...

Les côtés 14 de la deuxième cavité 17 de l'enceinte thermostatée sont constitués des côtés 44 de la cuve interne 40 qui sont vissés dans les côtés 34 de la cuve externe 30. Le fond 15 de l'enceinte thermostatée est constitué du fond 44 de la cuve interne 40 recouvert avec le joint 16, lui-même recouvert avec le fond 35 de la cuve externe 30.

La construction qui vient d'être décrite donne de bons résultats au point de vue stabilité thermique. Elle présente l'avantage de pouvoir être démontée en cas de panne du résonateur piézoélectrique 1.

L'enceinte thermostatée 10 possède en outre plusieurs éléments de chauffage 11 répartis sur sa surface extérieure. Les éléments de chauffage 11 sont, par exemple, des transistors de puissance dont les résistances thermiques sont choisies de façon à être les plus faibles possibles pour assurer un meilleur transfert de la chaleur à la surface extérieure de l'enceinte thermostatée 10. Les transistors de puissance peuvent être fixés par brasage en phase vapeur à la surface extérieure de l'enceinte thermostatée 10.

Le nombre d'éléments de chauffage 11 est supérieur ou égal à deux afin d'assurer une bonne répartition de la chaleur dans l'enceinte thermostatée 10.

Les fils de liaison 4 en sortie du résonateur piézoélectrique 1 passent à l'intérieur d'un conduit 13 situé dans l'épaisseur d'un côté 34 de la cuve externe 30. Le conduit se prolonge dans l'épaisseur d'un côté de la première cavité 6. Les fils de contacts 4 sont connectés au circuit électronique 5 constituant l'oscillateur placé à l'intérieur de la première cavité 6.

Les deux cavités 6, 17 constituant l'enceinte thermostatée 10 possèdent chacune un couvercle 18, 19. Les couvercles 18, 19 peuvent être fixés à l'enceinte thermostatée par des vis. Seules les vis 20 du couvercle 18 ont été représentées sur notre figure.

L'enceinte thermostatée 10 est introduite dans une enceinte secondaire 21 fermée. La forme intérieure de l'enceinte secondaire 21 épouse la forme extérieure de l'enceinte thermostatée 10. Un espace 22 étroit est aménagé entre les parois des deux enceintes 10, 21. Cet espace 22, dont la dimension est d'environ quelques millimètres permet de minimiser la convection lorsque l'on travaille à pression atmosphérique. Les deux enceintes ne sont en contact qu'au niveau de protubérances 23 situées par exemple sur les couvercles 18, 19 de l'enceinte thermostatée 10. Les protubérances 23 pourront être fixées par des vis, par exemple, à l'enceinte secondaire 21 afin de rendre solidaires les deux enceintes 10, 21. Sur notre figure, nous n'avons par représenté de moyen de fixation entre les deux enceintes. Ces protubérances pourraient aussi être situées sur la surface extérieure de l'enceinte thermostatée 10 ou même sur la surface intérieure de l'enceinte secondaire 21. Des freins thermiques 24 sont insérés à l'extrémité de chaque protubérance 23, au niveau du contact avec l'enceinte secondaire 21. Ces freins thermiques 24 sont réalisés dans un matériau isolant thermiquement tel qu'une résine contenant des fibres de verre.

Ils contribuent à isoler thermiquement l'enceinte thermostatée 10.

La surface intérieure de l'enceinte secondaire 21 subira un traitement de surface tel qu'un étamage brillant de façon à obtenir une faible emissivité. Cela permettra de minimiser les pertes par rayonnement qui se produisent lorsque l'on travaille dans le vide.

L'enceinte secondaire 21 est fermée par un couvercle 25 qui peut être solidaire de l'enceinte secondaire 21 par des vis. Ces vis n'ont pas été représentées sur notre figure. L'enceinte secondaire 21 peut être introduite dans un boitier qui constitue le boitier de l'oscillateur ultrastable. Ce boitier n'a pas été représenté afin de ne pas surcharger la figure.

L'enceinte thermostatée 10 est réalisée dans un matériau présentant une conductibilité thermique de l'ordre de 380W/m.°C et une chaleur massique entre 0°C et 100°C de l'ordre de 0,38 kJ/kg.°C. Le cuivre, l'aluminium ou un alliage de ces deux métaux conviennent parfaitement pour la réalisation de l'enceinte thermostatée 10. Chaque cuve pourra être réalisée dans un des matériaux cités précédemment. Les couvercles 18, 19 de l'enceinte thermostatée 10 seront également réalisés dans un matériau cité précédemment. L'enceinte thermostatée sera étamée sur toute sa surface extérieure afin de permettre le brasage des éléments de chauffage 11.

Sa surface intérieure sera également étamée afin que le capot 7 du résonateur 1 soit directement brasé à l'intérieur de l'enceinte thermostatée. C'est la surface intérieure de la cuve interne qui sera brasée afin de pouvoir y fixer le capot 7 du résonateur piézoélectrique 1. Le capot 7 du résonateur 1 est généralement en cuivre doré.

L'enceinte secondaire 21 est également réalisée dans un matériau bon conducteur de la chaleur. Les mêmes matériaux peuvent être utilisés pour les deux enceintes 10, 21.

## Revendications

1. Oscillateur ultrastable en fréquence comprenant un résonateur piézoélectrique (1) constitué d'une lame piézoélectrique encapsulée dans un boîtier composé d'un capot (7) et d'une embase (8), le résonateur (1) étant placé dans une enceinte thermostatée (10) comprenant des côtés (14) limités par un fond (15) et au moins un couvercle (18,19) l'enceinte thermostatée étant constituée d'une cuve interne (40) encastrée dans une cuve externe (30) leurs côtés (34,44) étant en contact direct et leurs fonds (35,45) formant le fond (15) de l'enceinte thermostatée caractérisé en ce que la surface extérieure du capot du résonateur est en contact thermique étroit avec les côtés (44) et le fond (45) de la cuve interne (40), et en ce que la cuve interne (40) est vissée a l'intérieur de la cuve externe (30), la cuve interne et la cuve externe étant réalisées chacune dans un matériau conducteur de la chaleur de manière à ce que l'oscillateur ait des performances de stabilité en fréquence aussi bonnes que possible à pression atmosphérique et sous vide.

2. Oscillateur selon la revendication 1, caractérisé en ce que le capot (7) est brasé à l'intérieur de la cuve interne (40).

3. Oscillateur selon l'une des revendications 1 ou 2, caractérisé en ce qu'un joint (16) thermique est inséré entre le fond (35) de la cuve externe (30) et le fond (45) de la cuve interne (40).

4. Oscillateur selon la revendication 3, caractérisé en ce que le joint thermique (16) est en métal tendre bon conducteur de la chaleur.

5. Oscillateur selon l'une des revendications 3 ou 4, caractérisé en ce que le joint thermique (16) est choisi parmi les métaux tels que l'indium, l'or, l'argent, le cuivre.

6. Oscillateur selon l'une des revendications 1 à 5, caractérisé en ce que le matériau conducteur de la chaleur est choisi parmi le cuivre, l'aluminium ou un de leurs alliages.

7. Oscillateur selon l'une des revendications 1 à 6, caractérisé en ce que l'enceinte thermostatée (10) est introduite dans une enceinte secondaire (21) fermée, la forme intérieure de l'enceinte secondaire (21) épousant la forme extérieure de l'enceinte thermostatée (10), un espace étroit (22) étant aménagé entre les deux enceintes (10, 21) afin de minimiser les phénomènes de convection.

8. Oscillateur selon la revendication 7, caractérisé en ce que l'espace étroit (22) est de l'ordre de quelques millimètres.

9. Oscillateur selon les revendications 7 ou 8, caractérisé en ce que des points de contact sont établis entre les deux enceintes par des protubérances (23) solidaires au moins de l'une des enceintes.

10. Oscillateur selon la revendication 9, caractérisé en ce que la surface de contact entre les deux enceintes est aussi faible que possible.

11. Oscillateur selon l'une des revendications 9 ou 10, caractérisé en ce qu'un frein thermique (24) est placé sur chaque protubérance (23) afin d'isoler thermiquement les deux enceintes (10, 21).

12. Oscillateur selon la revendication 11, caractérisé en ce que le frein thermique (24) est réalisé dans un matériau tel qu'une résine contenant des fibres de verre.

13. Oscillateur selon l'une des revendications 7 à 12, caractérisé en ce que la surface intérieure de l'enceinte secondaire (21) est rendue brillante par étamage afin de minimiser les pertes par rayonnement.

14. Oscillateur selon l'une des revendications 7 à 13, caractérisé en ce que l'enceinte secondaire (21) est réalisée dans un matériau bon conducteur de la chaleur tel que le cuivre, l'aluminium ou un alliage de ces métaux.

15. Oscillateur selon l'une des revendications 1 à 14, caractérisé en ce que la cuve externe de l'enceinte thermostatée forme deux cavités (6, 17) placées dos à dos, séparées par le même fond (15) et fermées par des couvercles (18, 19), la première (6) contenant un circuit électronique (5) de l'oscillateur, la seconde (17) contenant le résonateur (1) et la cuve interne (40).

## Claims

1. An oscillator which is ultrastable in frequency and comprises a piezoelectric resonator (1) made of a piezoelectric blade potted in a casing consisting of a base (8) and a cap (7), the resonator (1) being placed in a thermostatically controlled housing (10) defining side walls (14) which extend from a bottom (15) to at least one cover (18, 19), the thermostatically controlled housing being constituted of an inner tank (40) fitted into an outer tank (30), the side walls (34, 44) of these tanks being in direct contact and their bottoms (35, 45) defining the bottom (15) of the thermostatically controlled housing, characterized in that the outer surface of the cap of the resonator is in close thermal contact with the side walls (44) and the bottom (45) of the inner tank (40), and that the inner tank (40) is screwed into the outer tank (30), the inner and the outer tanks being made from a material of high thermal conductivity, such that the oscillator provides good performances of frequency stability both if operated at atmospheric pressure and if operated under vacuum.

2. An oscillator according to claim 1, characterized in that the cap (7) is brazed to the inside of the inner tank (40).

3. An oscillator according to one of claims 1 or 2, characterized in that a thermal seal (16) is inserted between the bottom (35) of the outer tank (30) and the bottom (45) of the inner tank (40).

4. An oscillator according to claim 3, characterized in that the thermal seal (16) is made of a soft metal of high thermal conductivity.

5. An oscillator according to one of claims 3 or 4, characterized in that the thermal seal (16) is selected from metals such as indium, gold, silver, copper.

6. An oscillator according to one of claims 1 to 5, characterized in that the material of high thermal conductivity is selected from copper, aluminum or their alloys.

7. An oscillator according to one of claims 1 to 6, characterized in that the thermostatically controlled housing (10) is introduced into a sealed secondary housing (21) whose inner shape is fitted to the outer shape of the thermostatically controlled housing (10), a narrow space (22) being provided between the two housings (10, 21) in order to minimize the convection phenomena.

8. An oscillator according to claim 7, characterized in that the narrow space (22) measures about some millimetres.

9. An oscillator according to claims 7 or 8, characterized in that points of contact are established between the two housings via projections (23) which are integral with at least one of these housings.

10. An oscillator according to claim 9, characterized in that the contact surface between the two housings is as small as possible.

11. An oscillator according to one of claims 9 or 10, characterized in that a thermal shield (24) is placed on each projection (23) in order to thermally isolate the two housings (10, 21) from each other.

12. An oscillator according to claim 11, characterized in that the thermal shield (24) is made of a material such as a resin charged with glass fibres.

13. An oscillator according to one of claims 7 to 12, characterized in that the inner surface of the secondary housing (21) is gloss-finished by tin plating in order to reduce the radiation losses.

14. An oscillator according to one of claims 7 to 13, characterized in that the secondary housing (21) is made of a material having a high thermal conductivity, such as copper, aluminum or an alloy of these metals.

15. An oscillator according to one of claims 1 to 14, characterized in that the outer tank of the thermostatically controlled housing presents two cavities (6, 17) arranged back to back, separated by a common bottom (15) and sealed by covers (18, 19), the first cavity (6) containing an electronic circuit (5) of the oscillator and the second cavity (17) containing the resonator (1) and the inner tank (40).

## Patentansprüche

1. Sehr frequenzstabiler Oszillator mit einem piezoelektrischen Resonator (1) bestehend aus einem piezoelektrischen Plättchen, das in einem aus einer Basis (8) und einer Kappe (7) gebildeten Gehäuse eingekapselt ist, wobei der Resonator (1) in einem Thermostatgefäß (10) untergebracht ist, dessen Seiten (14) von einem Boden (15) und mindestens einem Deckel (18, 19) begrenzt werden, wobei das Thermostatgefäß aus einem in einen äußeren Behälter (30) eingesetzten inneren Behälter (40) besteht, wobei die Seiten (34, 44) der beiden Behälter unmittelbar in Berührung stehen und ihre Boden (35, 45) den Boden (15) des Thermostatgefäßes bilden, dadurch gekennzeichnet, daß die äußere Oberfläche der Kappe des Resonators in engem thermischem Kontakt mit den Seiten (44) und dem Boden (45) des inneren Behälters (40) steht und daß der innere Behälter (40) in den äußeren Behälter (30) eingeschraubt ist und beide je aus einem gut wärmeleitenden Material bestehen, so daß der Oszillator gleich gute Eigenschaften der Frequenzstabilität bei atmospherischem Druck und im Vakuum besitzt.

2. Oszillator nach Anspruch 1, dadurch gekennzeichnet, daß die Kappe (7) im Inneren des inneren Behälters (40) eingelötet ist.

3. Oszillator nach einem der Ansprüche 1 oder 2, dadurch gekennzeichnet, daß eine thermische Dichtung (16) zwischen den Boden (35) des äußeren Behälters (30) und den Boden (45) des inneren Behälters (40) eingefügt ist.

4. Oszillator nach Anspruch 3, dadurch gekennzeichnet, daß die thermische Dichtung (16) aus einem weichen, gut wärmeleitenden Metall ist.

5. Oszillator nach einem der Ansprüche 3 oder 4, dadurch gekennzeichnet, daß die Wärmedichtung (16) unter den Metallen der Gruppe Indium, Gold, Silber, Kupfer ausgewählt ist.

6. Oszillator nach einem der Ansprüche 1 bis 5, dadurch gekennzeichnet, daß das gut wärmeleitende Material unter Kupfer, Aluminium und ihren Legierungen ausgewählt ist.

7. Oszillator nach einem der Ansprüche 1 bis 6, dadurch gekennzeichnet, daß das Thermostatgefäß (10) in ein verschlossenes Sekundärgefäß (21) eingefügt ist, wobei die innere Form des Sekundärgefäßes (21) der äußeren Form des Thermostatgefäßes (10) angepaßt ist und ein schmaler Abstand (22) zwischen den beiden Gefäßen (10, 21) verbleibt, um die Konvektionserscheinungen möglichst klein zu halten.

8. Oszillator nach Anspruch 7, dadurch gekennzeichnet, daß der enge Zwischenraum (22) in der Größenordnung von einigen Millimetern liegt.

9. Oszillator nach den Ansprüchen 7 oder 8, dadurch gekennzeichnet, daß Kontaktpunkte zwischen den beiden Gefäßen mittels Vorsprüngen (23) hergestellt werden, die mit mindestens einem der Gefäße fest verbunden sind.

10. Oszillator nach Anspruch 9, dadurch gekennzeichnet, daß die Kontaktoberfläche zwischen den beiden Gefäßen so gering wie möglich gewählt wird.

11. Oszillator nach einem der Ansprüche 9 oder 10, dadurch gekennzeichnet, daß ein thermischer Widerstand (24) auf jedem Vorsprung (23) angebracht ist, um die beiden Gefäße (10, 21) thermisch voneinander zu isolieren.

12. Oszillator nach Anspruch 11, dadurch gekennzeichnet, daß der thermische Widerstand (24) aus einem Material wie einem glasfaserverstärkten Harz besteht.

13. Oszillator nach einem der Ansprüche 7 bis 12, dadurch gekennzeichnet, daß die innere Oberfläche des Sekundärgefäßes (21) durch Verzinnen hochglänzend gemacht wird, um die Strahlungsverluste möglichst klein zu halten.

14. Oszillator nach einem der Ansprüche 7 bis 13, dadurch gekennzeichnet, daß das Sekundärgefäß (21) aus einem gut wärmeleitenden Material wie Kupfer, Aluminium oder einer Legierung dieser Metall besteht.

15. Oszillator nach einem der Ansprüche 1 bis 14, dadurch gekennzeichnet, daß der äußere Behälter des Thermostatgefäßes zwei Hohlräume (6, 17) bildet, die Rücken an Rücken liegen und durch einen gemeinsamen Boden (15) voneinander getrennt sind, sowie durch Deckel (18, 19) verschlossen sind, wobei der erste Hohlraum (6) eine elektronische Schaltung (5) des Oszillators und der zweite (17) den Resonator (1) und den inneren Behälter (40) enthält.
